# EUROPEAN PATENT APPLICATION

(11) **EP 1 793 595 A2**
(43) Date of publication of application: **06.06.2007**
(21) Application number: 06255889.5
(22) Date of filing: 17.11.2006
(51) Int. Cl.: H04N 5/445

(54) **Device control system, remote control device, and video display device**

(30) Priority: 02.12.2005 JP 2005349789
(71) Applicant: SONY CORPORATION, Tokyo 141 (JP)
(72) Inventor: Matsubayashi, Kei, Shinagawa-ku Tokyo 141 (JP)
(74) Representative: Robinson, Nigel Alexander Julian

(57) **Abstract**

Disclosed herein is a device control system including a video display device and a remote control device. The remote control device includes: an operation section; a detection section that detects movement of the remote control device; and a transmission section that transmits a first signal for making notification of the detected movement and a second signal for making notification of an operation performed on the operation section. The video display device includes: a reception section; a first storage section that stores the first signal and a preparatory operation; a second storage section that stores the second signal and a process corresponding to the second signal; and a control section configured to, if the first signal is received, perform the preparatory operation corresponding to the first signal, and, if the second signal is received, perform the process corresponding to the second signal.

## Description

The present invention relates to a device control system that is to be applied to a system in which a video display device, such as a television receiver, for displaying video is remotely controlled using a remote control device. The present invention also relates to a remote control device and a video display device applied to such a system.

For many years, remote control devices configured to transmit a control signal in a wireless manner, e.g., using infrared rays, have been used to remotely operate devices such as a television receiver, a videocassette recorder, a set-top box, and a personal computer.

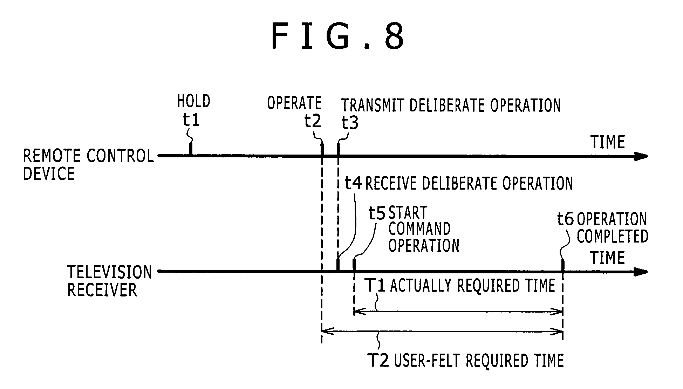

FIG. 8 illustrates exemplary operation timings of a related art remote control device configured to transmit a control signal and a television receiver (i.e., a device to be controlled). In FIG. 8, time axes are provided for the remote control device and the television receiver, and processes that accompany operations and operation timings are shown. Here, a moment at which a user takes a control device, such as the remote control device, in his or her hand is denoted as a "hold timing t1". Hereinafter, the control device will be mentioned as the "remote control device", but the concept of the control device encompasses all control devices that can be seen as serving to control a device to be controlled. When a button provided on the held remote control device is pressed, an operation is started at an operation timing t2. Then, after an infinitesimal time elapses, the control signal is transmitted to the device to be controlled, such as the television receiver, at a deliberate operation transmission timing t3 using infrared rays or the like. The control signal transmitted from the remote control device is received by a reception section of the television receiver at a deliberate operation reception timing t4.

After the received control signal is converted into a control signal for an internal device of the television receiver, an operation (i.e., a command operation) for which a command has been issued by the remote control device is started at a command operation start timing t5. Then, after a predetermined time elapses, the operation is completed at an operation completion timing t6. In this manner, remote control of the television receiver is accomplished by the remote control device. That is, the remote control is accomplished such that, after the operation timing t2, at which the user presses the button for the command operation, the command operation is performed at the command operation start timing t5 in the device to be controlled. Here, a time T1 that is actually required for the operation in the television receiver corresponds to a time between the command operation start timing t5 and the operation completion timing t6. Meanwhile, a time T2 that the user feels is required for the operation in the television receiver corresponds to a time between the operation start timing t2 and the operation completion timing t6. It can be seen that the time T2 is longer than the time T1 (i.e., T2 > T1).

As for input devices provided in remote control devices, in addition to devices (e.g., a button) configured to detect direct contact, devices (e.g., an acceleration sensor and an angular velocity sensor) configured to detect movement, such as shake, are increasingly installed in the remote control devices (examples of which include a cellular phone) as miniaturization and cost reduction of such movement detection devices have advanced.

Patent Document 1(Japanese Patent Laid-open No. 2000-148351 (FIG. 1)) includes a description of an operation command output device that enables a user to perform an operation by striking or shaking the device instead of by pressing a button.

In related art, the device to be controlled starts the operation for which the user has issued a command after the device to be controlled receives a deliberate operation deliberately performed by the user on the remote control device. In the case where the user performs an operation of turning on a power of a television receiver, for example, it takes several to tens of seconds for a light source unit not only of a cathode-ray tube but also of a rear projection television receiver or a backlight unit of a liquid crystal television receiver to reach an optimum state for display. Therefore, display becomes possible as late as when several to tens of seconds have passed after the user performs an operation of, e.g., pressing a power button. In addition, a time of approximately 10 to 30 seconds is needed for the brightness of an optical lamp to become stable. Although it is possible to arrange the optical lamp to be kept lighted at all times in order to shorten the time required to achieve the stability of the brightness of the optical lamp, this would result in a life of the optical lamp (approximately 5000 to 10000 hours) being shortened further, which is already shorter than that of a fluorescent tube of the liquid crystal display, or the like.

In the case where the user performs an operation of selecting a channel of the television receiver or a video, for example, even with a device equipped with two tuners, it is necessary to wait for a signal for signal demodulation or decoding in the case of digital broadcasting. Thus, after the user performs the operation of the channel selection, it takes approximately 2.3 seconds (a maximum value as stated in the ARIB standard specification STD-B32) for the channel selection to be completed in the case of digital terrestrial broadcasting.

In related art, such a waiting time is considered necessary in the case where the remote control device is used for operation. Even after the user performs the operation, he or she has to wait for the device to be controlled to complete the command operation while holding the remote control device in his or her hand. This long waiting time may cause the user to worry about device trouble or operation mistake and thereby suffer from mental stress.

The device disclosed in Patent Document 1 is a device that achieves an operation by an action, such as striking or shaking the device, instead of button pressing, and does not have a function of detecting a sign of operation, such as picking up of the device, and transmitting a predetermined operation command before the operation is actually performed.

With such a situation in view, an advantage of the present invention is, when a remote control device is used to operate a video display device (i.e., a device to be controlled), to shorten the time that a user feels is required for an operation to be completed.

According to one embodiment of the present invention, there is provided a device control system including a video display device having a display section configured to display video and a remote control device configured to remotely control the video display device. The remote control device includes: an operation section configured to operate the video display device; a detection section configured to detect movement of the remote control device; and a transmission section configured to transmit a first signal for making notification of the movement detected by the detection section and a second signal for making notification of an operation performed on the operation section. The video display device includes: a reception section configured to receive the first and second signals; a first storage section configured to store the first signal and a preparatory operation, the preparatory operation being a process to be performed in the video display device based on an operation that is expected to be performed on the operation section after the first signal is received by the reception section; a second storage section configured to store the second signal and a process to be performed in the video display device, the process corresponding to the second signal; and a control section configured to, if the first signal is received, perform the preparatory operation corresponding to the first signal, and, if the second signal is received, perform the process corresponding to the second signal.

According to another embodiment of the present invention, there is provided a remote control device configured to remotely control a video display device having a display section configured to display video. The remote control device includes: an operation section configured to operate the video display device; a detection section configured to detect movement of the remote control device; and a transmission section configured to transmit a first signal for making notification of the movement detected by the detection section and a second signal for making notification of an operation performed on the operation section.

According to yet another embodiment of the present invention, there is provided a video display device including: a display section configured to display video based on control by a remote control device capable of remotely controlling the video display device; a reception section configured to receive a first signal for making notification of movement of the remote control device and a second signal for making notification of an operation performed on the remote control device; a first storage section configured to store the first signal and a preparatory operation, the preparatory operation being a process to be performed in the video display device based on an operation that is expected to be performed on the remote control device after the first signal is received by the reception section; a second storage section configured to store the second signal and a process to be performed in the video display device, the process corresponding to the second signal; and a control section configured to, if the first signal is received, perform the preparatory operation corresponding to the first signal, and, if the second signal is received, perform the process corresponding to the second signal.

According to the above-described embodiments of the present invention, when the movement of the remote control device is detected, the preparatory operation is started in the video display device. Therefore, the time between when an operation is performed on the remote control device to start a process in the video display device and when the process is completed in the video display device can be shortened.

According to the above-described embodiments of the present invention, when the movement of the remote control device is detected, the preparatory operation is started in the video display device, and when an operation is performed on the remote control device, a process is started in the video display device. Thus, the time that a user feels is required for an operation to be completed can be shortened. That is, improved convenience of operation is achieved.

Embodiments of the invention will now be described, by way of example only, with reference to the accompanying drawings in which:
FIG. 1 is a block diagram illustrating an internal configuration of a device control system according to one example embodiment of the present invention;
FIG. 2 is a flowchart illustrating exemplary processing by a transmission control section according to one example embodiment of the present invention;
FIG. 3 is a flowchart illustrating exemplary processing by an analysis section according to one example embodiment of the present invention;
FIG. 4 is a flowchart illustrating exemplary processing by a control section according to one example embodiment of the present invention;
FIG. 5 is a flowchart illustrating exemplary processing by a learning section according to one example embodiment of the present invention;
FIG. 6 is a diagram for explaining an example of the time required for an operation by control by a remote control device according to one example embodiment of the present invention;
FIG. 7 is a diagram for explaining an exemplary case where an operation has not been performed by control by the remote control device according to one embodiment of the present invention; and
FIG. 8 is a diagram for explaining an example of the time required for an operation by control by a remote control device in related art.

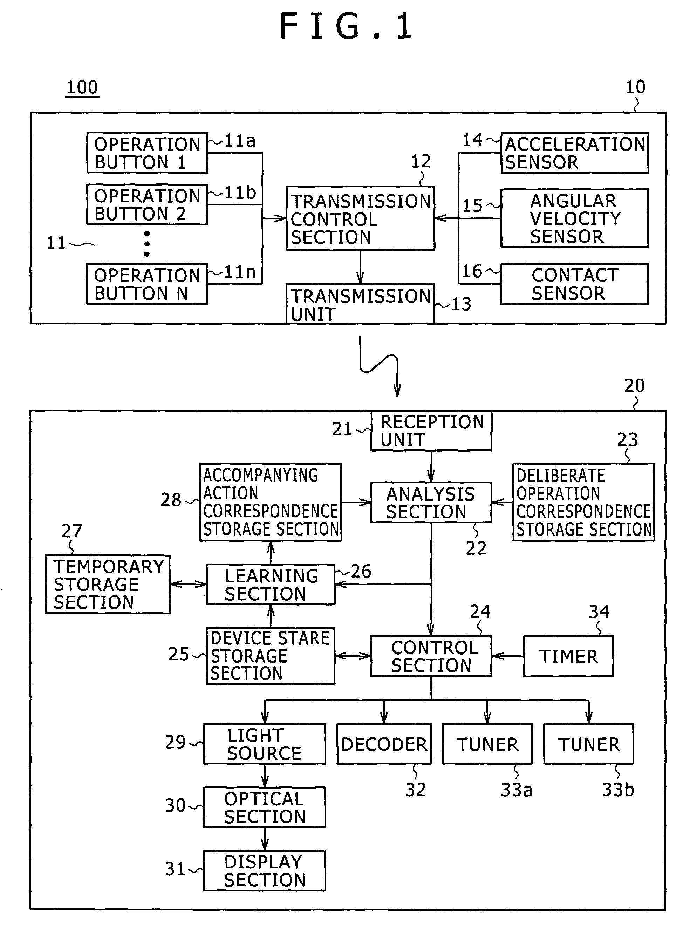

Hereinafter, one example embodiment of the present invention will be described with reference to FIGS. 1 to 7. This embodiment refers to an exemplary case where, when a shake or the like caused by a user picking up a remote control device for operation is detected by the remote control device, that shake or the like is transmitted to a television receiver as a sign of an operation, and the television receiver performs a predetermined process before actually starting the operation.

First, an exemplary configuration of this exemplary device control system will now be described with reference to FIG. 1. A rear projection type television receiver 20 for video display receives a television broadcast program via a tuner 33a or 33b that selects a specified channel from among a broadcast wave received by an antenna (not shown). For image display, a light source 29, such as a lamp, is lighted and an image is displayed on a display section 31 via an optical section 30 formed by a mirror, a lens, etc. A remote control device 10 that is capable of remotely operating the television receiver 20 is capable of transmitting an operation signal corresponding to an operation via wireless communication, such as using infrared rays. Such a system is a device control system 100 according to the present embodiment.

The remote control device 10 capable of remotely controlling the television receiver 20 includes operation buttons 11a to 11n provided on an operation section 11 that is used to perform operations of power on/off, channel selection, etc., as "deliberate operations" which will be described later. The operation section 11 is further provided with operation keys, such as an Up/Down key, a jog dial, or the like, in addition to the operation buttons. In the present embodiment, an action of deliberately operating any one of the operation buttons 11a to 11n is referred to as a "deliberate operation". Meanwhile, an action preceding the deliberate operation, such as an action of picking up the remote control device 10, is referred to as an "accompanying action". As devices for detecting such accompanying actions, the remote control device 10 includes an acceleration sensor 14 for detecting acceleration when the remote control device 10 has been picked up, an angular velocity sensor 15 for detecting an angular velocity such as rotation, and a contact sensor 16, such as a touch panel, for detecting a contact by a fingertip. Information detected by any of the sensors 14 to 16 and operation information provided from any of the operation buttons 11a to 11n are supplied to a transmission control section 12, which converts such information into an operation signal that accompanies a predetermined operation or the accompanying action (i.e., a sign of an operation). The operation signal obtained from the conversion is supplied to a transmission unit 13, which converts it into an infrared signal and transmits it. Thus, the infrared signal is transmitted to the television receiver 20 (i.e., a device to be controlled) via the transmission unit 13.

The infrared signal transmitted to the television receiver 20 is received by a reception unit 21 in the television receiver 20. The received infrared signal is subjected to a predetermined conversion process in the reception unit 21, and a resultant operation signal is supplied to an analysis section 22 configured to analyze a signal. Referring to an "accompanying action correspondence storage section" 28 that stores correspondence related to the accompanying action and is formed by, for example, a rewritable RAM (Random Access Memory) and a "deliberate operation correspondence storage section" 23 that stores correspondence related to the deliberate operation, the analysis section 22 recognizes a process (e.g., turning on of a power of the television receiver 20, or the like) in various parts that corresponds to the received operation signal, and supplies a control signal required for an operation to a control section 24 that controls various parts of the television receiver 20.

Based on the received control signal, the control section 24 lights the light source 29 and allows a projected image as enlarged by the optical section 30 to be displayed on the display section 31. Here, an operation of starting the decoding of an image or of starting the channel selection process upon receipt of the operation signal for the accompanying action is referred to as a "preparatory operation". Meanwhile, an operation that corresponds to and accompanies the deliberate operation is referred to as a "command operation". The control section 24 reads time information from a timer 34 that measures time, and thus measures a time for which the preparatory operation continues, for example. In addition, referring to a device state storage section 25 that stores a state of the device, the control section 24 performs the preparatory operation or the command operation, such as the turning on of the power, the channel selection, or volume up/down, in conjunction with a decoder 32 that decodes an MPEG (Moving Picture Experts Group)-2 format or any one of the tuners 33a and 33b that perform the channel selection, for example.

The accompanying action correspondence storage section 28 has stored therein the accompanying action detected by any of the sensors 14 to 16, such as a swing of an angle that is caused when the user picks up the remote control device 10, and an operation that was performed after the detection of the accompanying action. Then, referring to the device state storage section 25 that has stored therein the current state of the television receiver 20, the control section 24 controls an operation as necessary. In the device state storage section 25, the state of the television receiver 20 is updated as often as necessary by the control section 24. If the power of the television receiver 20 is in an Off state, for example, a process of lighting the light source 29 to turn on the power is started when the remote control device 10 has been picked up. Meanwhile, if the power of the television receiver 20 is in an On state, when the remote control device 10 has been picked up, operations of various parts are controlled so as to prepare for channel switching. As described above, depending on whether the power of the television receiver 20 is in the On state or in the Off state, necessary preparatory operations may differ.

While referring to the device state storage section 25, a learning section 26 that updates and controls the accompanying action correspondence storage section 28 with respect to a pair of the accompanying action and the preparatory operation allows a temporary storage section 27 formed by a rewritable RAM or the like to temporarily store correspondence between an unknown accompanying action, which may differ with each user, and a preparatory operation. Each time the operation signal for any accompanying action or any deliberate operation is supplied to the control section 24, a notification signal is provided to the learning section 26. For example, if it is found based on the control by the analysis section 22 that a command operation corresponding to the unknown accompanying action has occurred, the unknown accompanying action temporarily stored in the temporary storage section 27 is read therefrom and contents of the accompanying action correspondence storage section 28 is updated so that the unknown accompanying action is stored as a sign of that command operation.

Now, a process for detecting the sign using the remote control device 10 according to the present embodiment will be described below. With the remote control device 10, it is possible to perform the deliberate operation by pressing any of the operation buttons 11a to 11n. Such deliberate operations are known to the user as corresponding to operations executable in the television receiver 20 and are performed deliberately by the user. In addition, the remote control device 10 is capable of detecting the accompanying action, such as the shake or the movement of a finger, with the sensors 14 to 16. Such accompanying actions are distinct from the deliberate operations and performed by the user for the television receiver 20 in association with the deliberate operations. Thus, in the case where the remote control device has been picked up with the intention of pressing any operation button, for example, detection of the accompanying action is possible before the deliberate operation of "pressing" is performed. Moreover, the remote control device 10 transmits to the television receiver 20 not only the detected deliberate operation but also the detected accompanying action. This enables the television receiver 20 to recognize the accompanying action before the deliberate operation.

The television receiver 20 is provided with the deliberate operation correspondence storage section 23 that has stored therein the "deliberate operation" and an operation corresponding to the deliberate operation. The operation corresponding to the deliberate operation is referred to as the "command operation". The television receiver 20 is also provided with the accompanying action correspondence storage section 28 that has stored therein the accompanying action and an operation corresponding to the accompanying action. The operation corresponding to the accompanying action is referred to as the "preparatory operation" because it is an operation performed in preparation for the command operation that is expected to be performed following the accompanying action. Thus, the television receiver 20 is able to employ the correspondence between the deliberate operation and the command operation, and the correspondence between the accompanying action and the preparatory operation. The accompanying action correspondence storage section 28 achieves appropriate correspondence therebetween by updating it as necessary using a learning function of the learning section 26. Therefore, it is possible to improve the precision of the correspondence and cope with a change owing to the passage of time.

The television receiver 20 is also provided with the device state storage section 25 that stores the state of the device. Upon receipt of the deliberate operation, the television receiver 20 performs the command operation associated with the received deliberate operation in the deliberate operation correspondence storage section 23 in accordance with the state of the device. Upon receipt of the accompanying action, the television receiver 20 performs the preparatory operation associated with the received accompanying action in the accompanying action correspondence storage section 28 in accordance with the state of the device. Thus, it becomes possible to start the preparatory operation based on the accompanying action prior to the performance of the deliberate operation.

In the case where the television receiver 20 is of the rear projection type, after the power of the television receiver 20 is turned on, the light source 29 is lighted but does not reach a predetermined brightness soon. Therefore, by starting the lighting of the light source 29 as the preparatory operation, it is possible to shorten the time that the user feels is required for the lighting of the light source 29. In the case of channel switching in a television receiver that receives analog broadcasting, the channel switching takes approximately 0.5 seconds. Therefore, the user will be able to feel that the screen has been switched as soon as he or she performs an operation for that purpose.

In the case of a television receiver that receives digital broadcasting, however, channel switching takes approximately two seconds. This is because data for a screen is interleaved, for example, and a predetermined time is required for data corresponding to one screen to be prepared. Suppose, for example, that the tuner 33a is used for channel selection and a broadcast image is displayed. In this case, at the time when the remote control device 10 according to the present embodiment is picked up, a channel that will possibly be chosen as a result of the channel switching (for example, a channel immediately previous or subsequent in the Up/Down key) may be selected in advance by the other, unused tuner 33b so that an image for that channel is stored in a buffer memory (not shown). In the case where the touch panel or the like is used for the channel selection, the channel selection may be started in advance using the unused tuner upon detection of a channel number that a finger of the user is approaching before actual channel selection is performed. This makes it possible to display the image of the selected channel speedily after the actual channel selection is performed, and to thereby shorten the time that the user feels is required for the channel selection.

Suppose that the preparatory operation is being performed when the deliberate operation is received. In this case, if the command operation associated with the deliberate operation coincides with the command operation forecasted by the preparatory operation, transition is made from the preparatory operation to the command operation. Meanwhile, if the command operation associated with the deliberate operation does not coincide with the command operation forecasted by the preparatory operation, the preparatory operation is cancelled and then the command operation is performed. In the case where no preparatory operation is being performed when the deliberate operation is received, the command operation associated with the deliberate operation is performed. The television receiver 20 is equipped with the timer 34 for the case where no deliberate operation is performed when the preparatory operation is being performed. Based on the timer 34, the preparatory operation is cancelled when a predetermined set time has elapsed.

The above control makes it possible, in the television receiver 20, to cancel the preparatory operation in the case where no operation is performed during the predetermined time, in addition to enabling smooth transition from the preparatory operation to the command operation.

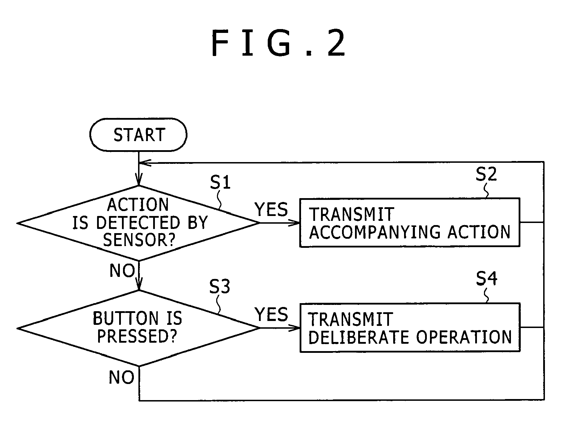

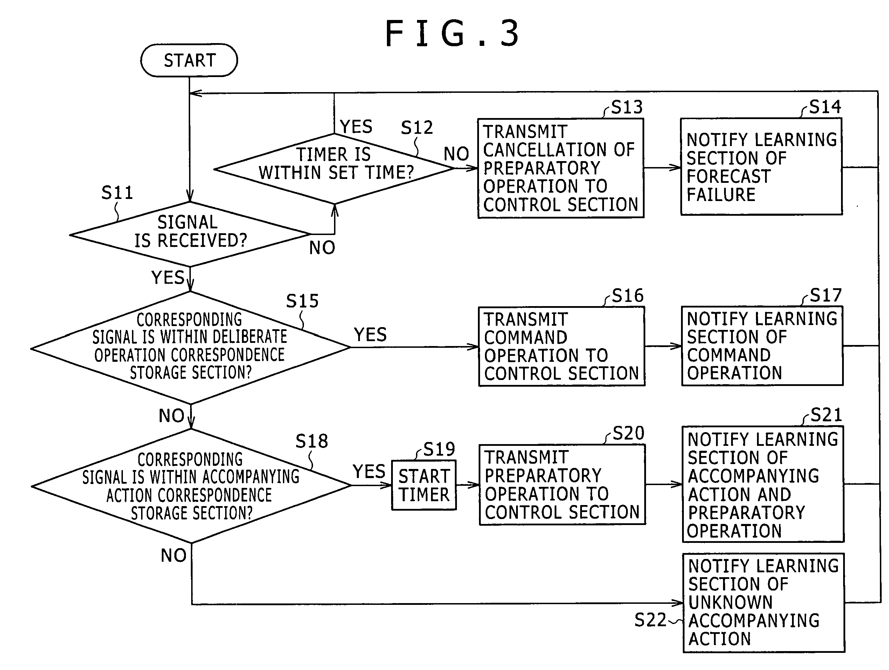

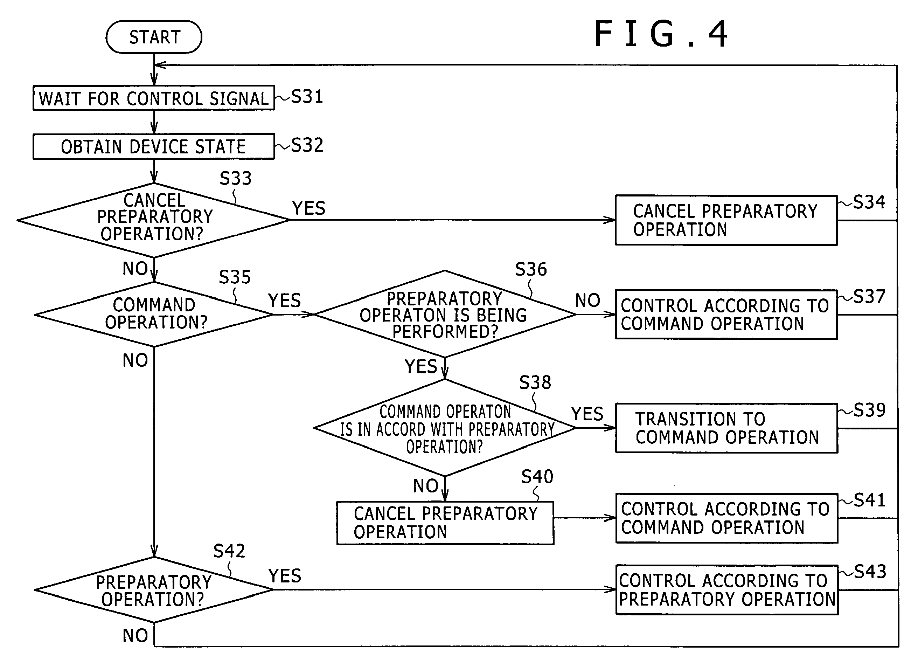

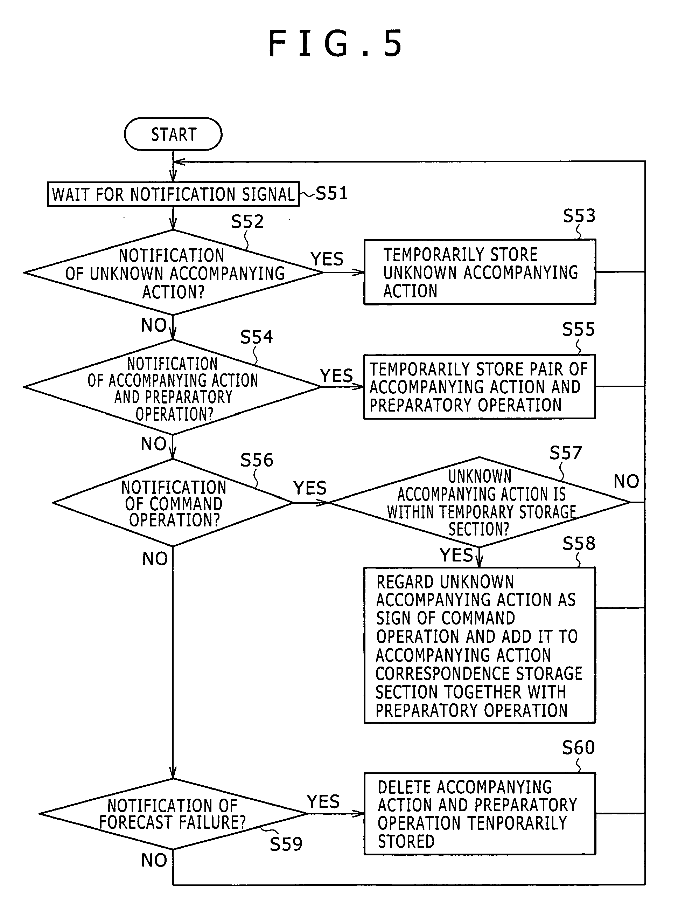

Next, with respect to the process for detecting a sign as employed in the present embodiment, processing by various parts will now be described with reference to flowcharts of FIGS. 2 to 5. FIG. 2 illustrates exemplary processing by the transmission control section 12 of the remote control device 10 according to the present embodiment. FIG. 3 illustrates exemplary processing by the analysis section 22 of the television receiver 20. FIG. 4 illustrates exemplary processing by the control section 24 of the television receiver 20. FIG. 5 illustrates exemplary processing by the learning section 26 of the television receiver 20.

First, the exemplary processing by the transmission control section 12 of the remote control device 10 will now be described below with reference to the flowchart of FIG. 2. First, it is checked whether a movement or approaching action of the remote control device 10 has been detected based on any one of or any combination of the acceleration sensor 14, the angular velocity sensor 15, and the contact sensor 16 (step S1). If the movement or approaching action has been detected, it is regarded as the accompanying action and the operation signal therefor is transmitted to the television receiver 20 (step S2). Then, control returns to step S1.

Meanwhile, if no action is detected by any of the sensors 14 to 16, it is checked whether any one of the buttons 11a to 11n has been pressed (step S3). If any one of the operation buttons 11a to 11n has been pressed, that pressing is regarded as the deliberate operation corresponding to the pressed button, and the operation signal therefor is transmitted to the television receiver 20 (step S4). Then, control returns to step S1. Meanwhile, if none of the operation buttons 11a to 11n has been pressed, control returns to step S1.

Next, the exemplary processing by the analysis section 22 of the television receiver 20 will now be described below with reference to the flowchart of FIG. 3. First, it is checked whether any operation signal corresponding to any accompanying action or any deliberate operation has been received from the remote control device 10 (step S11). If there is no reception of such an operation signal, it is checked whether a timer that may have been caused to start at the start of the preparatory operation has not exceeded the predetermined set time (step S12).

The timer is a value obtained by measuring the time obtained from the timer 34 and is used to allow the preparatory operation to continue for the predetermined set time and, when the timer has exceeded the predetermined set time, cause the preparatory operation to be cancelled. As long as the timer has not exceeded the predetermined set time, the processes of step S11 and S12 are repeated. Meanwhile, if the timer has exceeded the predetermined set time, a control signal that issues an instruction to cancel the preparatory operation is transmitted to the control section 24 (step S13).

Then, a notification signal corresponding to forecast failure is transmitted to the learning section 26, which has forecasted the preparatory operation corresponding to the accompanying action (step S14). In this case, there is no command operation corresponding to the accompanying action; therefore, the operation signal corresponding to the unknown accompanying action stored in the temporary storage section 27 is deleted, and update is not performed in the accompanying action correspondence storage section 28. Thereafter, control returns to step S11, and the process of checking the reception of the operation signal is performed again.

Meanwhile, if the operation signal has been received, it is checked whether the received operation signal has been stored in the deliberate operation correspondence storage section 23 (step S15). If the command operation corresponding to the received operation signal is stored in the deliberate operation correspondence storage section 23, a control signal corresponding to the command operation is transmitted to the control section 24 (step S16), and further, a notification signal for notification of the command operation is transmitted to the learning section 26 (step S17). Thereafter, control returns to step S11, and the process of checking the reception of the operation signal is performed again.

If the received operation signal is not stored in the deliberate operation correspondence storage section 23, it is checked whether the received operation signal is stored in the accompanying action correspondence storage section 28 (step S18). Suppose that as the accompanying action, unknown shake or the like was detected. In this case, if this shake (i.e., the accompanying action) is not stored in the accompanying action correspondence storage section 28, the shake is regarded as an unknown accompanying action, and a notification signal for notification thereof is transmitted to the learning section 26 (step S22).

Meanwhile, if the received operation signal is stored in the accompanying action correspondence storage section 28, the timer is started (step S19), and a control signal corresponding to a preparatory operation to be started is transmitted to the control section 24 (step S20). In addition, a notification signal corresponding to the preparatory operation and the accompanying action is transmitted to the learning section 26 (step S21). Thereafter, control returns to step S11, and the process of checking the reception of the operation signal is performed again.

Next, the exemplary processing by the control section 24 of the television receiver 20 will now be described below with reference to the flowchart of FIG. 4. First, the control section 24 waits until any control signal is received from the analysis section 22 (step S31). If any control signal is received, the current state of the television receiver 20 is obtained from the device state storage section 25 (step S32). The obtained current state of the television receiver 20 will be employed in various control steps described below. Then, it is checked whether the received control signal is an instruction to cancel the preparatory operation (step S33). If the received control signal is an instruction to cancel the preparatory operation, the preparatory operation is cancelled (step S34). Meanwhile, if the received control signal is not an instruction to cancel the preparatory operation, it is checked whether the received control signal corresponds to any command operation (step S35).

If the received control signal corresponds to any command operation, it is checked whether any preparatory operation is currently being performed in the television receiver 20 (step S36). For example, this process is a process of checking whether a process of selecting a channel that is expected to be selected, a process of capturing an image, or the like has already been started as the preparatory operation (assuming that the received control signal corresponds to the command operation of channel switching).

If no preparatory operation is being performed, control is performed according to the command operation (step S37). Then, control returns to step S31, and the control section 24 waits for any control signal. The process of step S37 is performed in the case where the command operation has been received without any preceding accompanying action. For example, this process corresponds to the case where any operation button is pressed while the remote control device 10 remains on a desk. In this type of operation, the accompanying action, such as previously picking up the remote control device 10, is not detected by any of the sensors 14 to 16; therefore, only the command operation is received.

Meanwhile, if any preparatory operation is being performed, it is checked whether the preparatory operation being performed is in accord with the command operation (step S38). If the preparatory operation being performed is in accord with the command operation, transition is made from the preparatory operation to the command operation (step S39). Meanwhile, if the preparatory operation being performed is irrelevant to the command operation, the preparatory operation is cancelled (step S40), and control is performed according to the command operation (step S41).

If it is determined at step S35 that the received control signal does not correspond to any command operation, it is checked whether the control signal that has reached the control section 24 is a signal corresponding to any preparatory operation (step S42). If the received control signal corresponds to any preparatory operation, control is performed according to the preparatory operation (step S43). If the received control signal does not correspond to any preparatory operation, control returns to step S31, and the control section 24 waits for any control signal.

Next, the exemplary processing by the learning section 26 of the television receiver 20 will now be described below with reference to the flowchart of FIG. 5. First, the learning section 26 waits until any notification signal is received from the analysis section 22 (step S51). Then, it is checked whether the received notification signal is a notification of any unknown accompanying action (step S52). If it is the notification signal corresponding to any unknown accompanying action, the received unknown accompanying action is temporarily stored in the temporary storage section 27 (step S53). Then, control returns to step S51, and the learning section 26 waits for any notification signal. Meanwhile, if the received notification signal does not correspond to any unknown accompanying action, it is checked whether the received notification signal corresponds to any known accompanying action and the preparatory operation (step S54).

If it is the notification of the known accompanying action and the preparatory operation, the pair of the accompanying action and the preparatory operation is temporarily stored in the temporary storage section 27 (step S55). Then, control returns to step S51, and the learning section 26 waits for any notification signal. Meanwhile, if the received notification signal is not the notification of the known accompanying action and the preparatory operation, it is checked whether the received notification signal is a notification of any command operation (step S56). If it is the notification of any command operation, it is checked whether any unknown accompanying action has previously been temporarily stored in the temporary storage section 27 (step S57).

If any unknown accompanying action has been temporarily stored in the temporary storage section 27, the unknown accompanying action is regarded as a sign of the command operation and is stored in the accompanying action correspondence storage section 28 together with the preparatory operation (step S58). Then, control returns to step S51, and the learning section 26 waits for any notification signal. Meanwhile, if no unknown accompanying action has been temporarily stored in the temporary storage section 27, control returns to step S51, and the learning section 26 waits for any notification signal.

If it is determined at step S56 that the received notification signal is not the notification of any command operation, it is checked whether the received notification signal is a notification of forecast failure (step S59). If the received notification signal is the notification of forecast failure, the pair of the accompanying action and the preparatory operation temporarily stored in the temporary storage section 27 is deleted (step S60). Meanwhile, if the received notification signal is not the notification of forecast failure, control returns to step S51, and the learning section 26 waits for any notification signal.

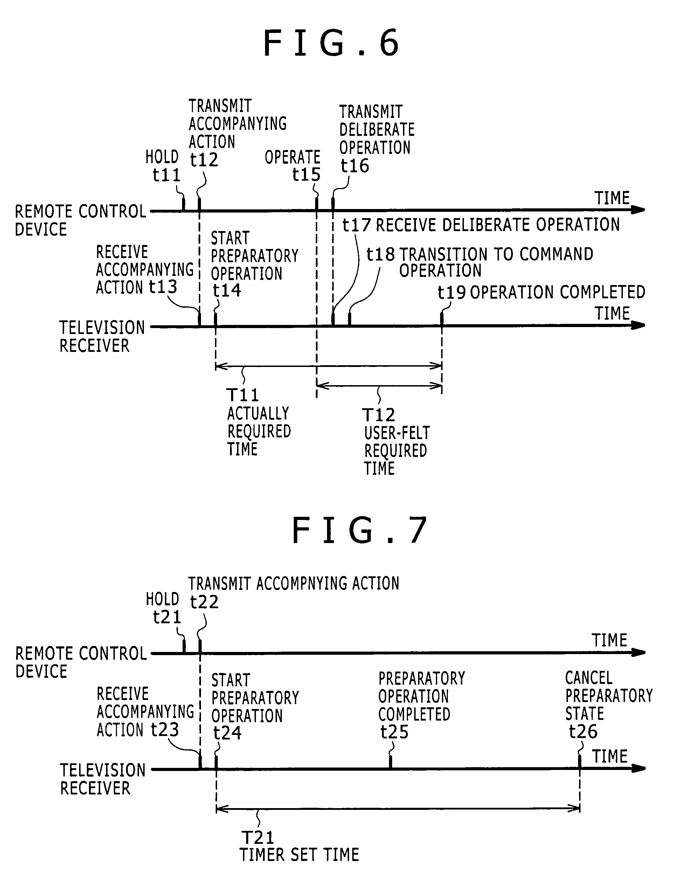

Here, an example of how the time that the user feels is required for operation, since the user's operation until the operation is completed in the television receiver 20, is shortened will now be described below with reference to FIG. 6. FIG. 6 illustrates an example of timings of operations of the remote control device 10 and the television receiver 20 in connection with the time required for an operation as controlled by the remote control device according to the present embodiment. In FIG. 6, time axes are provided for the remote control device 10 and the television receiver 20, and processes that accompany operations and operation timings are shown.

A moment at which the user picks up the remote control device 10 is denoted as a "hold timing t11". At this time, the accompanying action is detected by any of the sensors 14 to 16, and the accompanying action is transmitted to the television receiver 20 via the transmission unit 13 at an accompanying action transmission timing t12. The television receiver 20 receives the accompanying action at an accompanying action reception timing t13. In response to receipt of this accompanying action, the preparatory operation is started at a preparatory operation start timing t14.

If, after holding the remote control device 10, the user performs an operation, such as pressing of any of the operation buttons 11a to 11n, an operation is started at an operation timing t15. Then, after an infinitesimal time elapses, an infrared signal is transmitted to the television receiver 20 via the transmission unit 13 at a deliberate operation transmission timing t16 by using infrared rays or the like. The operation signal for the deliberate operation transmitted from the remote control device 10 is received by the reception unit 21 of the television receiver 20 at a deliberate operation reception timing t17.

After the received operation signal for the deliberate operation is converted in the television receiver 20 into control signals for various constituent parts, the command operation is started at a command operation transition timing t18 if the preparatory operation is meant for the command operation corresponding to the deliberate operation. Then, after a predetermined time elapses, the operation in the device is completed at an operation completion timing t19.

As described above, the preparatory operation can be started in the television receiver 20 at the timing at which the accompanying action is detected in the remote control device 10, and the command operation can be performed upon receipt of the deliberate operation.

Here, a time T11 that is actually required for the operation in the television receiver 20 corresponds to a time between the preparatory operation start timing t14 and the operation completion timing t19. However, a time T12 that the user feels is required for the operation in the television receiver 20 corresponds to a time between the operation start timing t15 and the operation completion timing t19. It can be seen that the time T11 is longer than the time T12 (i.e., T11 > T12).

Although the time actually required for the operation in the television receiver 20 is the time T11, the user feels that only the time T12 has been required for the operation in the television receiver 20 because it seems to the user that the operation started at the time when the deliberate operation, such as pressing of a button, was performed. Considering that, in related art, the time that the user feels is required for an operation is longer than the time actually required therefor, it follows that the time T12 that the user feels is required for the operation has been considerably shortened.

Next, an exemplary case where the preparatory operation has been performed in response to the detection of the accompanying action but the deliberate operation has not been performed will now be described below with reference to FIG. 7. FIG. 7 illustrates an example of timings of operations of the remote control device 10 and the television receiver 20 in connection with the time required for operation in the case where an operation has not been performed by control by the remote control device according to the present embodiment. In FIG. 7 also, time axes are provided for the remote control device 10 and the television receiver 20, and processes that accompany operations and operation timings are shown.

A moment at which the user has picked up the remote control device 10 is denoted as a "hold timing t21". At this time, the accompanying action is detected by any of the sensors 14 to 16, and the accompanying action is transmitted to the television receiver 20 via the transmission unit 13 at an accompanying action transmission timing t22. The television receiver 20 receives the accompanying action at an accompanying action reception timing t23. In response to receipt of this accompanying action, the preparatory operation is started at a preparatory operation start timing t24.

Then, after a predetermined time elapses, the preparatory operation is completed in the television receiver 20 at a preparatory operation completion timing t25, and a deliberate operation that is expected to be performed next is waited for. However, if the predetermined time set in the timer 34 passes, the preparatory state is cancelled at a preparatory state cancellation timing t26. At this time, a timer set time T21 corresponds to a time between the preparatory operation start timing t24 and the preparatory state cancellation timing t26.

In related art, the user is forced to wait long because the operation in the television receiver is started after the deliberate operation performed in the remote control device reaches the television receiver. In contrast, according to the above-described present embodiment, at the time when the accompanying action performed in the remote control device 10 has reached the television receiver 20, the preparatory operation for the expected command operation is started. Therefore, if the deliberate operation is actually performed, reduction in the time that the user feels is required for the operation to be completed is achieved.

In addition, when the device to be controlled is operated using the remote control device, the accompanying action, which accompanies the deliberate operation performed by the user on the remote control device, is detected and transmitted, and the device to be controlled starts the preparatory operation before receiving the deliberate operation. Therefore, the time from the user's operation until the completion of the operation in the device to be controlled is shortened, whereby the user is relieved from worry or anxiety, which he or she might have while waiting for the operation to be completed.

Further, in order to enhance the speed of activation at the time of turning on of the power, it is sometimes arranged that the light source section of a display is supplied with electricity at all times at the expense of increase in the amount of the standby power. Also, in order to enhance the speed of channel selection, it is sometimes arranged that an unused tuner is supplied with electricity at all times and used to receive a broadcast that will possibly be selected at the expense of increase in the amount of the standby power. According to the above-described present embodiment, however, the increase in the speed of the operation can be achieved without the need to supply electricity at all times as above. This is achieved by starting the preparatory operation after detecting the sign of the command operation, i.e., the accompanying action. Therefore, excessive energy consumption or shortening of product life as a result of supplying electricity at all times can be prevented from occurring.

The description of the above-described embodiment has been made with respect to the turn-on time of the rear projection television receiver. However, the same effects can also be achieved with other types of television receivers. In the case of a liquid crystal display (whose backlight unit is formed by cold cathode fluorescent lamps (CCFLs)), for example, it takes several seconds for the brightness to become stable, because the fluorescent tubes flicker for a short time like a fluorescent lamp at the turn-on time. In the case of a liquid crystal display (whose backlight unit is formed by a light emitting diode (LED)) or a plasma display panel, elements of the light emitting diode or the plasma display panel can complete activation almost in an instant. In ether case, however, software programs including an operating system (OS) and a tuner control software program are activated after turning on of a power to start tuning in to a channel that had been selected when the power was tuned off. Therefore, even if the activation of the display panel is accomplished in an instant, a time for program execution is required in addition to the time for channel selection (approximately 2.2 seconds). Therefore, starting the channel selection based on the detection of the sign produces the effect of allowing the user to perceive time shortening. In the case where retransmission is performed by Internet Protocol (IP) multicast for blind spots in the terrestrial digital broadcasting, the operation is similar in principle to that of streaming broadcasting in a computer device; therefore, streaming buffering takes time. As such, although tuning is not performed at the time of turning on of a power in relation to a radio wave, a buffering time is required and therefore, the use of the sign is effective.

Further, even in the case where two or more tuners are installed in the television receiver, the user will be able to feel the shortening of the time required for channel selection. In this case, by detecting a movement of a finger, a tilting of the remote control device, or the like as a sign of switching to a next program or of switching from the terrestrial digital broadcasting to the BS (Broadcasting Satellite) digital broadcasting, for example, it becomes possible to start channel selection in advance, whereby the time required for the operation to be completed is shortened. Suppose that only one tuner is installed in the television receiver, and the user, who is now viewing a video, attempts to switch from the video viewing to the terrestrial digital broadcasting. In this case, if a channel (which will be referred to as a "last channel") that had been selected when the video viewing was started continues to be selected while the video viewing is being carried out, the use of a sign makes no difference when the switch to the terrestrial digital broadcasting results in returning to the last channel. Moreover, the continued selection of the last channel does not cause significantly greater power consumption since it is possible to stop the decoder alone, for example. However, in the case where the switch to the terrestrial digital broadcasting does not result in returning to the last channel (e.g., in the case where the user enjoyed the BS digital broadcasting before viewing the video but now attempts to enjoy the terrestrial digital broadcasting after viewing the video), the use of the accompanying action as a sign may achieve the increase in the speed of channel selection.

Some television receivers in recent years have a Web browser function of connecting to the Internet and enabling browsing of a desired homepage. Thus, detecting a sign of activation of Web browser software while the Web browser software has not been activated yet can achieve the increase in the speed of the activation of the software. Suppose that, although not displayed yet, the Web browser software is internally running, e.g., staying memory-resident. In this case, when a sign of switching from viewing a television broadcast program to the Web browser is detected, for example, reloading may be performed to update the previously displayed page to the newest version. Next, suppose that the user uses an indicator cursor, a cross key, or the like to move the cursor to a click position and perform click. In this case, if the user moves a selection frame or the like across a page being displayed, from one link (a click position) to another on the page, and a sign of clicking is detected after a succession of such operations (i.e., moving of the selection frame or the like), download of a target page can be started before actual clicking of a link. As described above, in various cases, the time required for the operation to be completed can be shortened by starting the preparatory operation based on detection of the sign.

Further, in recent years, the DLNA (Digital Living Network Alliance) standard has been developed and devices that comply with the standard have been increasing. The DLNA standard enables a content (a video, music, a digital picture, etc.) stored in a video device, a personal computer, or the like on a home network to be fetched via the network and displayed on a display screen of a television receiver. Formerly, time delays have occurred when the content is read from a hard disk drive in a source device, when conversion (i.e., transcoding) of a compression codec is performed as necessary, and when buffering is performed as necessary. Suppose here that the user attempts to acquire a content list. In this case, in order to acquire a content list with a view to displaying on the television receiver a content stored in the computer device or the like on the home network, it is necessary to acquire information of contents that are present at the moment in respective devices on the home network, and this acquisition currently requires several to tens of seconds. If the acquisition of the information of the contents that are present in the devices on the home network is started upon detection of a sign of displaying the content list, the acquisition of the list can be achieved quickly. Also suppose that the user attempts to play back or display a content. In this case, by starting acquisition of the content in advance when a sign of playing back or displaying the content on the home network is detected, the playback or display of the content can be started quickly.

The description of the above-described embodiment has been provided with respect to the control between the remote control device and the television receiver. However, the present invention is not limited to this device control system 100. Any combination of a remote control device and a device to be controlled is possible. The remote control device may be embodied by a very common device, such as a remote control device for a television broadcast receiver. Alternatively, the remote control device may be embodied by a cellular phone that has a remote control function as an application. Alternatively, the remote control device may be embodied by a media player characterized by the portable size and a display that permits viewing or listening at any desired location, a hand-held game machine, a television receiver that can be taken outdoors, or a display terminal that controls a device that works in conjunction with a wireless television receiver. Because many of such devices have already installed therein a sensor designed for another purpose, the present invention can be more easily implemented with such devices than with very simple remote control devices which are very commonly used for television broadcast receivers. In the case of a cellular phone terminal, hand-held game machine, or the like that has a sensor function, functions and effects equivalent to those of the remote control device described in the above-described embodiment can be achieved by updating a program therein so as to become capable of detecting the accompanying action and causing the preparatory operation to be started.

Note that, for communication between the device to be controlled and the control device, either unidirectional communication, such as infrared-ray communication, or bidirectional wireless communication that complies with the Bluetooth (registered trademark) or IEEE 802.11a/b/g standard may be employed. In the case of the former, infrared-ray communication, it is desirable that an infrared ray reception section of the device to be controlled be arranged at a position that is visible from a position of an infrared ray transmission section of the remote control device. Therefore, it may sometimes difficult that the moment when the user picks up the remote control device to operate it, the accompanying action be conveyed to the device to be controlled. In the case of the latter, wireless communication, however, communication between a transmission section of the remote control device and a reception section of the device to be controlled can be achieved even if the two sections are not visible from each other. That is, the communication therebetween can be achieved if only the distance therebetween is short enough. Therefore, it is possible to notify the device to be controlled of the accompanying action more quickly and securely.

In the above-described embodiment, coming of the deliberate operation, such as pressing of a button, is forecasted based on detection of the accompanying action. Examples of the accompanying action include actions (such as shaking) whose direct relation with the deliberate operation varies depending on the user and usage situation and actions whose direct relation with the deliberate operation is close, such as the position or movement of a finger as detected by the contact sensor arranged above or around a button. In the latter case, more accurate forecast of the relation between the accompanying action and the deliberate operation is achieved, such as whether or not the finger is about to press a power button, whether or not the finger is about to directly select a particular broadcast station, or whether or not the finger is about to select an adjacent broadcast station using an Up/Down key.

Also note that, in the above-described embodiment, learning and update are performed by the learning section 26 and the accompanying action correspondence storage section 28 so that the precision in forecast of the command operation can be improved. However, learning does not have to be performed, and the correspondence may never be changed after it is set in a factory. In this case, the need for the learning section 26 is eliminated, and therefore, simplification of the structure of the device and easier manufacture of the device are achieved.

Note that the above-described embodiment refers to exemplary cases where the command operation and the preparatory operation performed in the device to be controlled for which speed enhancement is achieved are a pair of the turning on of the power and the preceding activation of the optical section of the display (i.e., the supply of electricity to the optical section, such as a lamp, of the rear projection television receiver, or to the backlight unit of the liquid crystal display panel), or a pair of the channel selection and the preceding start of the reception of the broadcast wave, the digital broadcasting, the streaming broadcasting, etc. However, the present invention is not limited to such examples. They may be a pair of the channel selection (decoding) and preceding decoding in the decoder of a non-reference picture, such as an I-picture, or storage thereof, or a pair of trick play or start of playback in a video recorder and preceding loading or rotation of a drive or reading from a hard disk drive. The present invention is also applicable to various other operations, such as initial setting, acquisition of data (e.g., a title list), or the like in connection with a device, such as a camcorder, a computer device, a television receiver, or a video device. Such operations may be achieved via a USB (Universal Serial Bus) or a network cable.

Also note that, in the above-described embodiment, the sensors are used to detect the accompanying action. However, in the case where the touch panel is used as an operation section, instead of a button, the contact sensor is used for the deliberate operation. Various types of sensors are applicable to the touch panel, such as a resistive sensor, a capacitive sensor, an infrared sensor, and an ultrasonic sensor. Thus, it is possible to detect the movement of a finger before the contact of the finger with a surface of the touch panel. Therefore, it is possible to detect, as the accompanying action, the approach or movement of a finger before the direct contact of the finger with the panel.

Also note that a plurality of preparatory operations that are assigned priorities may be stored for a single accompanying action, and that the preparatory operation to be started may be selected according to the priorities. Also note that it may be so arranged that a plurality of preparatory operations are started in parallel upon detection of the accompanying action for the channel switching. By thus starting the preparatory operation(s) for the operation that is expected to be performed, it is possible to shorten the time required for the operation to be completed.

The present invention contains subject matter related to Japanese Patent Application JP 2005-349789, filed in the Japanese Patent Office on December 2, 2005, the entire contents of which being incorporated herein by reference.

It should be understood by those skilled in the art that various modifications, combinations, subcombinations and alterations may occur depending on design requirements and other factors insofar as they are within the scope of the appended claims or the equivalents thereof.

## Claims

1. A device control system, comprising:
a video display device including a display section configured to display video; and
a remote control device configured to remotely control said video display device,
wherein said remote control device includes
an operation section configured to operate said video display device,
a detection section configured to detect movement of said remote control device, and
a transmission section configured to transmit a first signal for making notification of the movement detected by the detection section and a second signal for making notification of an operation performed on the operation section, and
wherein said video display device includes
a reception section configured to receive the first and second signals,
a first storage section configured to store the first signal and a preparatory operation, the preparatory operation being a process to be performed in said video display device based on an operation that is expected to be performed on the operation section after the first signal is received by the reception section,
a second storage section configured to store the second signal and a process to be performed in said video display device, the process corresponding to the second signal, and
a control section configured to, if the first signal is received, perform the preparatory operation corresponding to the first signal, and, if the second signal is received, perform the process corresponding to the second signal.

2. The device control system according to claim 1,
wherein said video display device further includes a timer section configured to measure time, and
wherein the control section, if the first signal is received, controls the preparatory operation to continue for a predetermined set time obtained from the timer section and, if the second signal is not received within the predetermined set time, stops the preparatory operation.

3. The device control system according to claim 2,
wherein said video display device further includes a third storage section configured to store a state of said video display device, and
wherein the control section allows the third storage section to store the state of said video display device, and, if the first signal is received, controls the preparatory operation to continue for the predetermined set time obtained from the timer section and, if the second signal is received within the predetermined set time, obtains the state of said video display device from the third storage section and performs in said video display device the process corresponding to the second signal in accordance with the state of said video display device.

4. The device control system according to claim 3,
wherein said video display device further includes
a fourth storage section configured to temporarily store the first signal and the preparatory operation corresponding to the first signal, and
a learning section configured to allow the first storage section to store the first signal and the preparatory operation corresponding to the first signal and allow the fourth storage section to temporarily store the first signal and the preparatory operation corresponding to the first signal,
wherein the learning section allows the fourth storage section to temporarily store the first signal received,
wherein, if the second signal is received within the predetermined set time in a case where the first signal has not been stored in the first storage section, the learning section regards the process performed in said video display device based on the second signal as the preparatory operation corresponding to the first signal temporarily stored in the fourth storage section, and allows the first storage section to store the first signal and the preparatory operation corresponding to the first signal temporarily stored, and
wherein, if the second signal is not received within the predetermined set time in the case where the first signal has not been stored in the first storage section, the learning section deletes the first signal temporarily stored in the fourth storage section.

5. The device control system according to claim 3,
wherein said video display device further includes one or more tuners configured to perform channel selection, and
wherein the preparatory operation is a process of causing an unused one of the one or more tuners to start the channel selection in a case where a power of said video display device is in an On state according to the obtained state of said video display device.

6. The device control system according to claim 3,
wherein said video display device further includes a light source configured to light the display section, and
wherein the preparatory operation is a process of starting lighting of the light source in a case where a power of said video display device is in an Off state according to the obtain state of said video display device.

7. The device control system according to claim 1,
wherein the detection section is constituted by a combination of at least one of an acceleration sensor and an angular velocity sensor.

8. The device control system according to claim 1,
wherein the detection section is constituted by a contact sensor configured to detect approach of an object instead of detecting the movement of said remote control device.

9. A remote control device configured to remotely control a video display device having a display section configured to display video, the remote control device comprising:
an operation section configured to operate said video display device;
a detection section configured to detect movement of said remote control device; and
a transmission section configured to transmit a first signal for making notification of the movement detected by said detection section and a second signal for making notification of an operation performed on said operation section.

10. A video display device, comprising:
a display section configured to display video based on control by a remote control device capable of remotely controlling the video display device;
a reception section configured to receive a first signal for making notification of movement of the remote control device and a second signal for making notification of an operation performed on the remote control device;
a first storage section configured to store the first signal and a preparatory operation, the preparatory operation being a process to be performed in the video display device based on an operation that is expected to be performed on the remote control device after the first signal is received by the reception section;
a second storage section configured to store the second signal and a process to be performed in the video display device, the process corresponding to the second signal; and
a control section configured to, if the first signal is received, perform the preparatory operation corresponding to the first signal, and, if the second signal is received, perform the process corresponding to the second signal.
